# EUROPEAN PATENT SPECIFICATION

(11) **EP 1 417 740 B1**
(45) Date of publication and mention of the grant of the patent: **12.07.2006**
(21) Application number: 02739585.4
(22) Date of filing: 30.05.2002
(51) Int. Cl.: H01S 3/13

(54) **APPARATUS AND METHOD FOR CONTROLLING THE OPERATING WAVELENGTH OF A LASER**
VORRICHTUNG UND VERFAHREN ZUR STEUERUNG DER BETRIEBSWELLENLÄNGE EINES LASERS
APPAREIL ET PROCEDE DE REGLAGE DE LA LONGUEUR D'ONDE DE FONCTIONNEMENT D'UN LASER

(30) Priority: 31.05.2001 US 871230
(43) Date of publication of application: 12.05.2004
(73) Proprietor: Altitun AB, 175 29 Järfälla (SE)
(72) Inventor: VILHELMSSON, Kennet, S-433 50 Partille (SE); BROBERG, Bjorn, S-182 61 Djursholm (SE); PLASTOW, Robert, Badby, NN11 3AW (GB)
(74) Representative: Prins, Adrianus Willem
(86) International application number: PCT/US2002/017299
(87) International publication number: WO 2002/097936

(56) References cited:
- EP-A- 0 818 859
- WO-A-00/23764
- WO-A-95/20144
- US-A- 4 173 442
- US-A- 5 428 700
- US-B1- 6 233 263
- PATENT ABSTRACTS OF JAPAN vol. 012, no. 111 (E-598), 8 April 1988 (1988-04-08) -& JP 62 242378 A (KOMATSU LTD), 22 October 1987 (1987-10-22)
- PATENT ABSTRACTS OF JAPAN vol. 014, no. 408 (E-0972), 4 September 1990 (1990-09-04) -& JP 02 153583 A (MITSUBISHI ELECTRIC CORP), 13 June 1990 (1990-06-13)
- PATENT ABSTRACTS OF JAPAN vol. 017, no. 453 (E-1417), 19 August 1993 (1993-08-19) -& JP 05 102589 A (MITSUI PETROCHEM IND LTD), 23 April 1993 (1993-04-23)
- PATENT ABSTRACTS OF JAPAN vol. 014, no. 194 (E-0919), 20 April 1990 (1990-04-20) & JP 02 039582 A (TOSHIBA CORP), 8 February 1990 (1990-02-08)

## Description

### Field of the Invention

The present invention is directed generally to tunable laser diodes and more particularly to a method and apparatus for monitoring and controlling the operating wavelength of a laser diode.

### Background

The widespread introduction of wavelength division multiplexed (WDM) optical transmission systems relies on the availability of optical transmitters operating at precisely controlled wavelengths. Such transmitters typically use wavelength selected laser diodes as the optical source. Typical WDM systems operate with many wavelengths, uniformly spaced by frequency, operating in the so-called C-band, a window of gain provided by the erbium-doped fiber amplifier. For example, in accordance with the optical communications standards set by the International Telecommunications Union (ITU), a WDM system may operate with 80 channels of different wavelengths uniformly spaced by a channel spacing of 50 GHz. It is anticipated that future systems will operate with greater numbers of channels and with smaller interchannel spacings.

It is also desirable that WDM systems operate with lasers that are locked to the particular channel frequency, without long-term drift. If the wavelength of the laser drifts, the system may suffer unacceptable crosstalk in adjacent channels. A typical requirement is that the output of the laser does not drift by more than 3 GHz over a span of twenty years. A typical laser diode will naturally drift by an amount considerably greater than 3 GHz over this time period, the actual amount of the drift being dependent on specific aging characteristics of the laser.

This time-dependent frequency drift can be minimized, if not avoided altogether, by wavelength locking the laser, that is deliberately changing an operating characteristic of the device that affects the output wavelength, such as temperature or current, to compensate for the natural frequency drift. This requires a fixed, known frequency reference. It is often desirable for network management purposes that each laser be locked locally to its own reference, preferably within the laser diode package. It is also desirable that a single, standard reference assembly can be used with any one of a multitude of fixed frequencies, or with a tunable laser capable of operation at any such wavelength. This enables a widely tunable laser to be used at any of the channel frequencies, and avoids the requirement that the laser be selected to operate within only a small fraction of the channels.

Various wavelength locking solutions have been proposed, including the use of crystal gratings and fiber Bragg gratings, interference filters and etalons. Crystal and fiber Bragg gratings are optimized for operation at one wavelength and do not fit easily into a standard laser diode package. Interference filters can fit inside a laser package, but are optimized for only one wavelength.

Etalons have been the subject of significant development in wavelength locking schemes. However, when used with multiple wavelengths, etalons are extremely sensitive to angular alignment and thickness tolerances. This is because the absolute wavelength and the wavelength spacing are both a function of etalon thickness and angle. Since the thickness cannot be varied, both the thickness and angle must be held to a tight tolerance.

Therefore, there is a need for an approach to stabilizing the wavelength of a laser output that is low cost, easily adjustable in production and sufficiently compact to fit into a standard laser package. Furthermore, since the wavelength locker may be used to stabilize the output from a backup laser diode that substitutes for a laser that has failed, the wavelength locker should operate at any wavelength over the WDM band.

### Summary of the Invention

Generally, the present invention relates to an approach to locking the output wavelength of a laser that uses an etalon having non-parallel surfaces. Under this approach, the non-parallel etalon is formed from a readily available, low cost optical component. This approach offers significant advantages over the use of a planar etalon. It provides two degrees of freedom in alignment of the device, and so both the absolute wavelength and the spacing between the interference fringes can be independently adjusted. It also reduces the cost and difficulty of assembly, since it utilizes standard optical parts with wide tolerances. The invention may be used within a standard laser package.

In one particular embodiment of the invention, a laser system includes a laser producing output light and a non-planar etalon coupled to receive at least a portion of the output light. The non-planar etalon has at least one non-planar surface. The output light received by the non-planar etalon is formed into a fringe pattern. A detector unit has first and second detecting portions that detect respective first and second portions of the fringe pattern.

In another embodiment of the invention, a method of stabilizing an output wavelength of a laser includes forming an etalon fringe pattern using light generated by the laser incident on a non-planar etalon and detecting amounts of light in first and second portions of the etalon fringe pattern. The laser wavelength is then adjusted in response to the detected amounts of light in the first and second portions of the etalon fringe pattern.

In another embodiment of the invention, a laser system includes a laser that produces output light. A reflective, fringe-producing element is disposed in at least a portion of the output light to reflect a second light beam containing a fringe pattern. A light detector unit has a plurality of light detector elements disposed to detect at least two portions of the fringe pattern and to determine a wavelength of the light based on a phase of the fringe pattern relative to the light detector elements.

Another embodiment of the invention is directed to a laser system that includes a laser that produces a light output. An etalon is mounted to provide at least translational and tilt adjustments of the etalon relative to the light output, the etalon producing a fringe pattern from the light output. A detector unit is disposed to detect at least first and second portions of the fringe pattern.

Another embodiment of the invention is directed to a method of stabilizing the output wavelength of a laser. The method includes forming an etalon fringe pattern using light generated by the laser incident on a non-planar etalon, and detecting amounts of light in first and second portions of the etalon fringe pattern. An operating wavelength of the laser is adjusted in response to the relative phase of the fringe pattern determined from the detected amounts of light in the first and second portions of the etalon fringe pattern.

Another embodiment of the invention is directed to a wavelength stabilized laser that includes non-planar means for forming an etalon fringe pattern using light generated by the laser, and means for detecting amounts of light in first and second portions of the etalon fringe pattern. The system also includes means for adjusting an operating wavelength of the laser in response the phase of the fringe pattern relative to the means for detecting based on the detected amounts of light in the first and second portions of the etalon fringe pattern.

Another embodiment of the invention is directed to a method of locking the operating wavelength of a laser, comprising directing light from a laser to an etalon. The position of the etalon is adjusted in a direction perpendicular to the direction of the light incident on the etalon. Also, a tilt orientation of the etalon is adjusted relative to the direction of the light incident on the etalon. At least two portions of a fringe pattern generated by the light incident on the etalon are detected to form respective detector signals.

Another embodiment of the invention is directed to a wavelength locked laser that has means for directing light from a laser to an etalon and means for adjusting position of the etalon in a direction perpendicular to a direction of the light incident on the etalon. The laser also has means for adjusting a tilt orientation of the etalon relative to the direction of the light incident on the etalon, and means for detecting at least two portions of a fringe pattern generated by the light incident on the etalon to form respective detector signals.

Another embodiment of the invention is directed to a method of stabilizing an output wavelength of a laser. The method includes forming an interference fringe pattern using light generated by the laser incident on a reflective, fringe-producing element. Amounts of light in first and second portions of the interference fringe pattern formed by light reflected from the non-planar etalon are detected. The detected amounts of light are indicative of a relative phase of the interference fringe pattern relative to the detector unit. The operating wavelength is adjusted in response to the detected amounts of light in the first and second portions of the etalon fringe pattern.

Another embodiment of the invention is directed to a laser system that has reflective fringe-producing means for forming an etalon fringe pattern using light generated by the laser. Detecting means detect amounts of light in first and second portions of the etalon fringe pattern formed by light reflected from the reflective fringe-producing means non-planar, the amounts of light in the first and second portions of the etalon fringe the pattern being indicative of the phase of the fringe pattern relative to the detecting means. The system also include means for adjusting an operating wavelength in response to the phase of the fringe pattern relative to the detecting means.

It is noted that patent publication US 4 173 442 discloses a laser system having a Fizeau interferometer that has wedge-shaped surfaces. Further, patent publication EP 0 818 859 discloses a laser system comprising a Fabry-Perot etalon having parallel surfaces. Also patent publication WO00/23764 discloses a laser system with an etalon having parallel surfaces.

The above summary of the present invention is not intended to describe each illustrated embodiment or every implementation of the present invention. The figures and the detailed description which follow more particularly exemplify these embodiments.

### Brief Description of the Drawings

The invention may be more completely understood in consideration of the following detailed description of various embodiments of the invention in connection with the accompanying drawings, in which:
FIG. 1 schematically illustrates an optical configuration of laser and a non-parallel etalon used for wavelength locking, according to an embodiment of the present invention;
FIGs. 2A-2D schematically illustrate different configurations of non-parallel etalon and optical beam incident on the non-parallel etalon;
FIG. 3 schematically illustrates a fringe pattern reflected from a non-parallel etalon and indicates relative detector positions for detecting the fringe pattern, according to the present invention;
FIG. 4 schematically illustrates a fringe pattern produced by a non-parallel etalon and indicates relative detector positions spaced apart by approximately 90°, according to the present invention;
FIG. 5 schematically illustrates detector signals as a function of wavelength, according to the present invention;
FIG. 6 schematically illustrates an embodiment of a system for adjusting and stabilizing wavelength of a tunable laser, according to the present invention;
FIG 7 presents steps for an embodiment of a method for locking emission wavelength according to the present invention;
FIGs. 8A and 8B schematically illustrate degrees of freedom of adjustability for a non-parallel etalon and planar etalon respectively;
FIG. 9 schematically illustrates a detector configuration used with circular fringes produced by a non--planar etalon according to an embodiment of the present invention;
FIGs. 10A and 10B schematically illustrate detector configurations used with linear fringes produced by a non-planar etalon according an embodiment of the present invention;
FIGs. 11A and 11B illustrate an embodiment of the present invention using a prism etalon; and
FIG. 12 schematically illustrates an optical communications system that includes a laser whose wavelength is stabilized according to the present invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the invention as defined by the appended claims.

### Detailed Description

The invention provides a compact wavelength monitoring assembly for use in conjunction with tunable laser sources. The wavelength monitoring assembly is used for stabilization of the emission wavelength and for locking the wavelength to an electrical reference signal. The compact optical configuration of the assembly makes the device particularly well suited for incorporation inside standard packages that are used in telecommunications applications.

In general, the present invention is directed to a new approach to wavelength locking that employs an etalon having non-parallel surfaces. This approach offers two significant advantages over the use of a planar etalon. First, it provides two degrees of freedom in alignment of the device, and so both the absolute wavelength and the spacing between the interference fringes can be independently adjusted. Second, it reduces the cost and difficulty of assembly, since it utilizes standard optical parts having with wide tolerances.

The invention is directed to a compact wavelength monitoring assembly for use in conjunction with tunable laser sources. The wavelength monitoring assembly is used for stabilization of the emission wavelength and for locking the wavelength to an electrical reference signal. The compact optical configuration of the assembly makes the device particularly well suited for incorporation inside standard packages that are used in telecommunications.

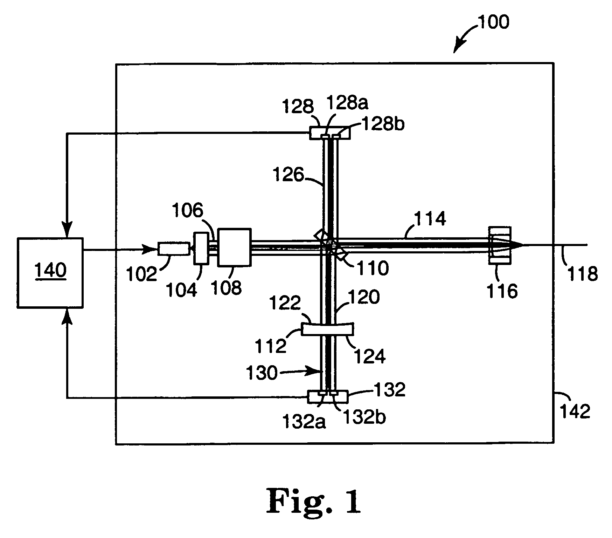

One particular embodiment of a wavelength stabilized tunable source 100 is schematically illustrated in FIG. 1. Light is generated by a tunable semiconductor laser 102. The laser may be any suitable type of semiconductor laser that produces a tunable output. Monolithically tunable lasers are often used in optical communications applications, such as distributed Bragg reflector (DBR) lasers, grating coupled, sampled Bragg reflector (GCSR) lasers, for example as described in "74 nm Wavelength Tuning Range of an InGaAsP Vertical Grating Assisted Codirectional Coupler Laser with Rear Sampled Grating Reflector" by M. Oberg et al., IEEE Photonics Technology Letters, Vol. 5, No. 7, pp. 735-738, July 1993, and in U.S. Patent No. 5,621,828, and vernier, dual DBR lasers, for example as described in U.S. Patent No. 4,896,325.

The divergence of the light emitted by the laser 102 is reduced using a lens 104. The light beam 106 passing out of the lens 104 may be approximately collimated, or may be convergent or divergent. In the sense used here, the term "collimated" means that the convergence or divergence of the light beam is negligible over the beam path of interest. For purposes of clarity, it is assumed in the following description that the light beam 106 is collimated. It will be appreciated, however, that the present invention also operates convergent and divergent light.

The light beam 106 passes through an optical isolator 108, which permits light to pass in the forward direction, but which blocks light passing in the backwards direction from reaching the laser 102. This prevents reflected light from re-entering the laser cavity and adversely affecting the stability of the light output form the laser. After passing through the isolator 108, a beamsplitter 110 splits a fraction of the beam 106 for transmission to a non-parallel etalon (NPE) 112. The remaining beam 114 may be directed to a focusing lens 116 for coupling into a fiber 118. Typically, the optical power coupled into the fiber 118 constitutes the useful output light from the laser 102 and is used for forming an optical communications signal. Typically, the optical power in the probe beam 120, directed to the NPE 112, is around a few per cent of the power in the remaining beam 114.

One purpose of the present invention is to monitor the emission wavelength of the laser 102 and to provide control signals that can be used for stabilizing the wavelength to an external reference. The emission wavelength of the laser 102 can thereby be stabilized to a predefined value. Thus, the laser 102 may be operable at one of a number of optical channel wavelengths.

The probe beam 120 propagates to the NPE 112, which operates as a spatial wavelength selective filter. The NPE 112 is formed from material that transmits light at the output wavelength of the laser 102, for example glass or plastic. The NPE 112 has surfaces that are non-parallel, and may be wedged or may include at least one non-planar surface. A non-planar surface may assume any type of shape, including spherical, aspherical, toroidal, or cylindrical shapes. If the etalon includes a non-planar surface, it may be referred to as a non-planar etalon.

In the illustrated embodiment, the first face 122 of the NPE 112 has an optical reflectivity R1 and a radius of curvature r1. The second face 124 has an optical reflectivity R2 and a radius of curvature r2. The magnitudes of the surface reflectivities, R1 and R2, may be equal, although they need not be equal. For example, if the NPE 112 is formed from glass having uncoated surfaces 122 and 124, then the reflectivities R1 and R2 are determined by the difference in refractive index between the material of the NPE 112 and the medium in which the NPE 112 is immersed. If the NPE 112 is formed from glass, having a refractive index of around 1.5, and is immersed in air, then the reflectivity of each surface 122 and 124 is around 4%. It will be appreciated that the surfaces 122 and 124 may also be provided with coatings having specific reflective values in the range from greater than 0% to 100%. In the present invention, the reflectivities R1 and R2 typically lie in the range 1% - 50%, but need not be restricted to this range.

The surfaces 122 and 124 may also have different values of r1 and r2. In the illustrated embodiment, r1 has a negative value, and thus exhibits negative refracting power, while r2 is infinite, so that the second surface 124 is flat. It will be appreciated that the present invention is not restricted to this arrangement of the surfaces 122 and 124. The surfaces 122 and 124 may exhibit positive, negative, or zero refracting power. In a wedged NPE 112, both surfaces 122 and 124 have infinite radius of curvature.

When the probe beam 120 is incident on the NPE 112, the beam 120 experiences multiple reflections off the first and second surfaces 122 and 124 inside the NPE 112. Consequently, the light incident on the NPE 112 is partially reflected at the first surface 122 and partially transmitted into the material of the NPE 112. This partially transmitted beam propagates towards the second surface 124 where it is again partially transmitted and partially reflected. The light undergoes a series of internal reflections within the NPE 112. The total optical power reflected from the NPE 112 towards the beamsplitter 110 may be determined from coherent addition of all partially reflected beams. Likewise, the total optical power transmitted through the NPE 112 in the forward direction may be determined by coherent addition of all partially transmitted beams. The term "coherent addition" means that the optical fields of the partial field contributions are added using the field amplitude and phase.

The light beam 126 reflected by the NPE 112 may be detected using a detector unit 128. The detector unit 128 is able to detect phase information of the interference fringe pattern formed by the NPE 112, and may be a spatially modulated detector having at least two detecting portions 128a and 128b, for example photodetectors, that independently detect portions of the reflected beam 126, as will be described below. The detector unit 128 may also include an array of detecting portions. Alternatively, the detector unit 128 may include a large area detector to detect the entire reflected beam 126.

The light beam 130 transmitted through the NPE 112 may be detected using a detector unit 132. Like the detector unit 128, detector unit 132 may be a spatially modulated detector having at least two detecting portions 132a and 132b to detect phase information of the interference fringe pattern transmitted through the NPE 112. In addition, one of the detector units 128 and 132 may be a large area detector positioned to detect the entire reflected beam 126 or transmitted beam 130. One or both of the detector units 128 and 132 may be present.

In an advantageous embodiment of the present invention, the detector unit 128 includes two detecting portions 128a and 128b for monitoring the wavelength of the light emitted by the laser 102, in the manner described below, while the detector unit 132 includes a large area detector to detect the entire transmitted beam 130. The signal produced by the large area detector is proportional to the power of the light output by the laser 102 and, with suitable calibration, may be used to monitor the power output by the laser 102. An advantage of this approach is that the detector unit 128 may detect a fringe pattern in the reflected beam 126. This is due in part to the larger dynamic range of the reflected fringe pattern, that is the relative difference between the maximum and minimum detected signals. Thus, it is easier to detect a fringe pattern in the reflected beam 126, even when the surface reflectivities, R1 and R2, are low.

In another embodiment of the present invention, the detector unit 132 may include two independent detectors 132a and 132b for monitoring the laser wavelength while the detector unit 128 includes a large area detector for monitoring the power output by the laser 102.

The reflected beam 126 and the transmitted beam 130 are spatially modulated over their respective beam cross-sections since the optical path through the NPE 112 varies as a function of transverse position. Consequently, interference fringes are formed in the beams 126 and 130. Cross-sectional areas of the respective beams 126 and 130 that correspond to constructive interference are relatively brighter regions, while regions that correspond to destructive interference are relatively dark regions.

The laser 102 operates under control of a control unit 140. The control unit 140 provides one or more currents to respective sections of the laser 102 for providing gain and for tuning the laser 102 to a desired wavelength. The control unit 140 may also control the operating temperature of the laser 102, for example by controlling a thermoelectric cooling unit on which the laser 102 is mounted, or by controlling the internal temperature of the housing 142 surrounding the laser system. The control unit 140 may also be connected to receive detection signals from the detector units 128 and 132. The control unit 140 may adjust one or more of the currents that tune the laser 102 in response to the signals received from the detector units 128 and 132. Laser sources in WDM transmitter systems are typically operated at constant power level, so the control unit 140 may adjust the drive current to achieve constant power from the laser 102, in response to the signals received from one or more of the detector units 128 and 132.

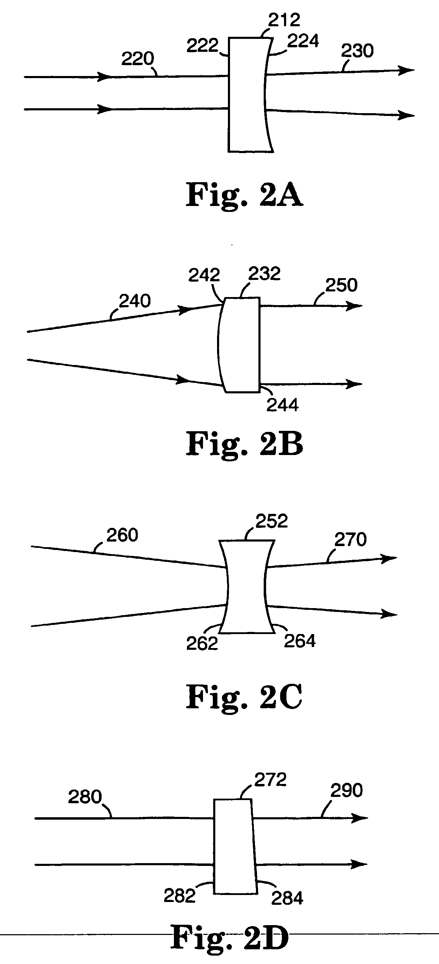

As was indicated above, the light incident on the NPE 112 may be in different states of collimation, and the NPE itself 112 may have more than one curved surface and may also exhibit positive or negative refractive power. This is illustrated schematically further in FIGs. 2A - 2D, which show further embodiments of NPE 112. In FIG. 2A. the probe beam 220 is collimated, and is incident on an NPE 212 that has a flat first surface 222 and a concave second surface 224 that provides negative refractive power. Consequently, the transmitted beam 230 diverges away from the NPE 212.

In FIG. 2B, the probe beam 240 is diverging as it enters the NPE 232. In this particular embodiment, the NPE 232 has a convex first surface 242 that provides positive refractive power and a flat second surface 244. Consequently the divergence of the transmitted beam 250 is less than the divergence of the probe beam 240.

In FIG. 2C, the probe beam 260 is converging as it enters the NPE 252. In this particular embodiment, the NPE 252 has a concave first surface 262 and a concave second surface 264, each of which provides negative refractive power. Consequently the divergence of the transmitted beam 270 is greater than the divergence of the probe beam 260.

In FIG. 2D, the probe beam is collimated as it enters the NPE 272. In this particular embodiment, the NPE 272 is wedged, with flat surfaces 282 and 284. Consequently, the divergence of the transmitted beam 290 is the same as divergence of the probe beam 280.

It will be appreciated that different combinations of NPE surfaces may be used with probe beams of different degrees of collimation, convergence or divergence. It will also be appreciated that the NPE need not be used with light extracted from the output at the front of the laser 102, but may also be used with light leaking from the rear of the laser 102.

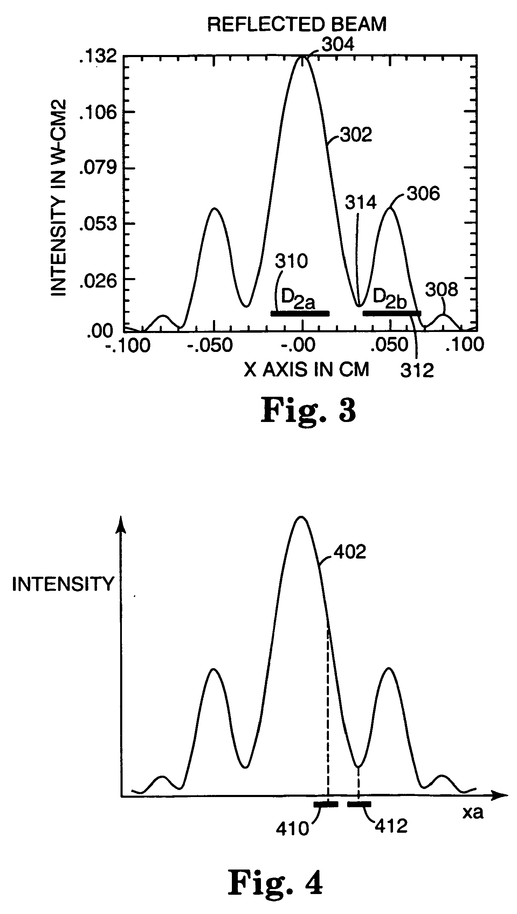

An example of an interference fringe pattern 302 in the reflected beam 126 is illustrated in FIG. 3, as measured in the plane of the detector unit 128. The fringe pattern 302 is shown as a plot of intensity vs. spatial position, x. This fringe pattern corresponds to one generated by a NPE having a circularly symmetric, curved surface, such as a spherical or aspherical surface. The dominant center peak 304 corresponds to the center fringe of a circular fringe pattern, and the first peak 306 corresponds to the first outer ring fringe.

The interference pattern 302 varies periodically with wavelength when the wavelength of the light produced by the laser 102 is changed monotonically. The fringe pattern 302 shows a fringe separation between the center fringe 304 and the first fringe 306 of around 0.05 cm. The fringe separation between the first fringe 306 and second fringe 308 is approximately 0.03 cm. Thus, the fringe spacing varies with position across the beam. Therefore, if the detector unit 128 includes two detectors spaced apart by 0.05 cm, shown respectively as 310 and 312, then the first detector 310 detects a large signal resulting from the center fringe 304 and the second detector detects a signal resulting for the first fringe 306.

The pattern of bright and dark fringes varies when the wavelength is tuned. If, for example, a certain spatial co-ordinate of the beam 126 exhibits a fringe of maximum brightness at a first wavelength, then the irradiance at that particular spatial co-ordinate decreases as the wavelength of the output from the laser 102 is changed monotonically, reaching a minimum brightness value at a second wavelength. If the laser output wavelength continues to be changed, the brightness of the spatial co-ordinate of the beam 126 increases back to a maximum value for a third wavelength. The value of the second wavelength is approximately mid-way between the values of the first and third wavelengths.

The particular formation in which the fringes change with wavelength is dependent on the shapes of the surfaces of the NPE. For example, for a NPE having a curved surface that is circularly symmetrical, such as a spherical surface, the fringe pattern is typically circular. The fringes expand or contract radially, depending on the direction of the change in wavelength. When a wedged NPE is used, the fringes are typically linear. The fringes move in a direction parallel to the inter-fringe spacing when the wavelength is changed.

The phase difference between any two arbitrary spatial co-ordinates in the fringe pattern is dependent on the wavelength of the light passing through the NPE. When measuring the wavelength of a laser operating in a WDM transmitter, the total tuning range of the light is small relative to the wavelength. For example, the laser light may be tuned over a range of about 0.2% of its wavelength. As a result of changing the wavelength, the fringe separation also changes by only about 0.2%. Therefore, since the fringe separation change over the tuning range of the laser is so small, it may be assumed that the phase difference between two arbitrary spatial co-ordinates of the fringe pattern is constant over the tuning range, irrespective of the actual wavelength.

Since the two detectors 310 and 312 detect fringe peaks simultaneously, as illustrated in FIG. 3, the detectors may be said to be "in phase", or separated by 360°. This need not be the case, and the detector spacing may be selected so that the two detectors do not detect fringe peaks simultaneously. For example, detector 310 may be positioned to detect the center fringe 304 while detector 312 is positioned to detect the signal minimum 314. In such a case, the detectors are said to be out of phase, or separated by 180°.

In some cases, it is advantageous not to have the detector spacing at either 180° or 360°, since the derivative of the detector signal with respect to wavelength may be close to zero for both detectors when the separation is either 180° and 360°. Thus, it may be difficult to determine whether the wavelength is increasing or decreasing. If, on the other hand, the separation between the detectors 410 and 412 is at some intermediate value, for example 90° as illustrated for the fringe pattern 402 in FIG. 4, then for no wavelength is there a condition where the derivative of the detector signal with wavelength is close to zero for both detectors, at least over the tuning range of interest. Where the detector separation is 90°, the derivative of the signal produced by one of the detectors is close to a maximum value when the derivative of the signal of the other detector is close to zero. More broadly stated, the derivative of the signal produced by one of the detectors is close to a maximum value when the derivative of the signal of the other detector is close to zero for detector spacings of 90° plus integral multiples of 180°.

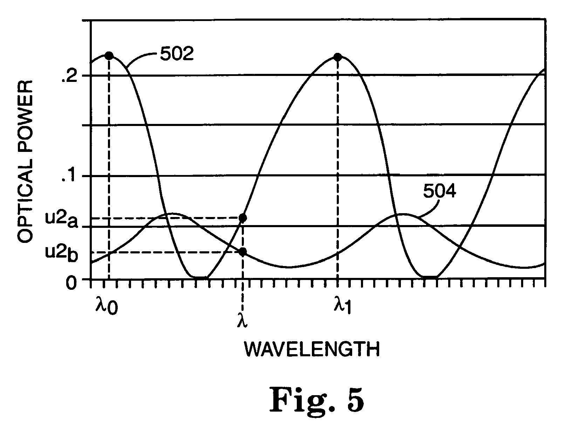

Use of the invention for stabilizing the output wavelength of the laser 102 is now discussed with respect to FIG. 5, which schematically illustrates the periodic behavior of the signals from a pair of detectors in a detector unit 128 or 132, with respect to changing wavelength. An advantage of using a detector unit 128 that detects light reflected by the NPE 112, rather than light transmitted through the NPE 112 is that, where the values of reflectivity of the NPE surfaces 122 and 124 are significantly less than 100%, the fringe pattern is superimposed on a low background signal. In other words, the visibility of the fringes in the reflected beam 126 may be higher than the visibility of the fringes of the transmitted beam 130, at least when the reflectivity of the NPE surfaces is relatively low. The ability to detect a fringe pattern from a low reflectivity etalon reduces the manufacturing tolerances on the NPE 112, permitting the use of a relatively inexpensive, lower precision optic than is typically required in the high reflectivity, planar etalons typically used where the transmitted fringe pattern is measured.

Another advantage arising from detection of a reflected fringe pattern is that the transmitted beam 130 may be used for monitoring the power level. Measuring total power by using the transmitted beam 130 instead of the reflected beam 126 is easier and more accurate since the greater transmitted signal is advantageous to accurate power measurement.

The signal from the first detector as a function of wavelength is shown as curve 502, and the signal from the second detector as a function of wavelength is shown as curve 504. The detectors are spaced apart by an amount so that their respective signals 502 and 504 are out of phase by about 90°. The desired laser output wavelength is given as λₛ. At this selected wavelength, the signal detected by the first detector is u1 and the signal detected by the second detector is u2. The signals u1 and u2 unambiguously specify the wavelength within one period of the NPE wavelength characteristics. The NPE characteristic period is also referred to as the free spectral range (FSR). Thus, assuming that it is known in which particular period of the detector characteristic the laser is operating, then the control unit 140 may adjust the operating wavelength of the laser to maintain the detector signals at u1 and u2. It is also apparent from FIG. 5 that the laser 102 may be locked to any predefined set of detector values u1 and u2, thereby locking the laser diode to any predefined wavelength within the particular period of the wavelength characteristics.

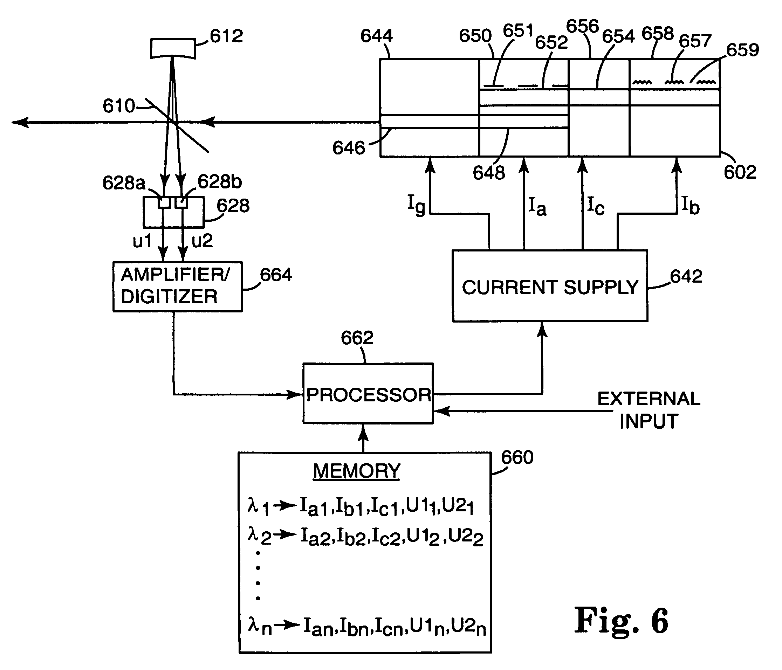

The use of the present invention for locking the wavelength of a laser is described further with respect to FIG. 6. The laser 602, is operated by a number of currents from a current supply 642. The description herein is directed to the use of a GCSR laser, but the technique is also applicable to other types of laser, including the vernier dual DBR laser. The GCSR laser 602 includes a gain section 644 having an active waveguide 646 where light passing along the waveguide 646 is amplified. The waveguide 646 is connected to a waveguide 648 in a grating coupler section 650. The output waveguide 652 from the coupler section 650 is coupled to a waveguide 654 that passes through a phase control section 656 to a sampled distributed Bragg reflector (SDBR) section 658. The grating coupler section 650, the phase control section 656 and the SDBR section 658 provide adjustable frequency selection, so that the laser 602 operates in a single longitudinal mode whose wavelength can be selected continuously over a large range.

The laser 602 is tuned through the use of injection currents passing through the different tuning sections 650, 656 and 658. Course wavelength tuning is provided adjusting current la passing into the grating coupler section 650. The grating coupler section 650 includes a codirectional coupler whose coupling efficiency is enhanced by a grating 651. Adjustment of the current density in the grating coupler region, resulting from changes in Ia, leads to a change in the refractive indices of the layers in the coupler section 650. Consequently, the relatively broad wavelength range over which the grating coupler section 650 effectively couples light from the lower waveguide 648 to the output waveguide is scanned.

Intermediate wavelength selection is provided by adjusting current Ib passing through the SDBR section 658. The SDBR section 658 includes a number of DBR sections 657 separated by non-DBR regions. The SDBR section 658 typically manifests a reflection spectrum that includes a number of peaks spaced apart from one another. The combined wavelength selectivity of the grating coupler section 650 and the SDBR section 658 results in the selection of only one of the SDBR reflectivity peaks. Adjustments in tuning current la result in different SDBR reflectivity peaks being selected. Adjustments in tuning current Ib result in changes in the refractive index of the of the DBR regions, with a concomitant shift in the wavelength of the selected reflectivity peak.

It will be appreciated that other frequency selective structures may be used, in addition to the SDBR structure. For example, a superstructure grating DBR (SSGDBR) may be used, as is discussed in "114 nm Wavelength Tuning Range of a Vertical Grating Assisted Codirectional Coupler Laser with a Super Structure Grating Distributed Bragg Reflector", by P-J Rigole et al., IEEE Photonics Technology Letters, Vol. 7, No. 7, pp. 697 - 699, July 1995.

Fine control of the wavelength is provided by adjusting the current Ic passing through the phase control section 656. Adjustment of the current Ic changes the carrier density in the phase control section 656, thus providing control over the optical path length of the phase control section 656, resulting in a change in the effective cavity length of the laser 602. The wavelength selectivity of the grating coupler section 650 and the SDBR section 658 is sufficient to select a single longitudinal mode. Thus, a change in the cavity length of the laser 602 alters the wavelength of the single longitudinal mode emitted by the laser 602.

Selective adjustment of each of Ia, Ib and Ic may result in substantially continuous tuning of the output of the laser 602 over a large wavelength range. Furthermore, it is possible to map the currents, Ia, Ib and Ic, to particular values of wavelength. This is advantageous when the laser 602 operates in a WDM system, where the laser 602 is required to operate at any one of a number of discrete wavelengths for generating a signal at the ITU standard wavelengths.

Prior to field implementation, the particular values of Ia, Ib, and Ic required for operating the laser 602 at each of the ITU standard optical communications channel wavelengths, λ₁, λ₂, ....λₙ, may be measured and stored in a memory unit 660. In addition, the detector values, u1ᵢ and u2ᵢ, may be measured for each standard wavelength λᵢ, and also stored in the memory 660. Thus, the memory 660 includes a look-up table that relates a unique combination of values of Ia, Ib, Ic, u1 and u2 for each standard wavelength. The value of Ic is typically selected so that λᵢ is within the acceptable tolerance of the standard wavelength, and the side mode suppression ratio (SMSR) is maximized.

Subsequently, after the laser 602 has been implemented in the field, the laser 602 is set to operate at a selected one of the ITU standard wavelengths, λᵢ. The processor 662 extracts the currents Iaᵢ, Ibᵢ, and Icᵢ, from the memory 660 and directs the current supply 642 to apply the currents Iaᵢ, Ibᵢ, and Icᵢ, to the respective laser sections 650, 658 and 656. The processor 662 may select the particular operating wavelength in response to a control signal received from an input 664.

The present invention teaches a method that allows locking an arbitrary laser emission wavelength by maintaining the two detector signals, u1 and u2, at constant values. However, the laser can be tuned to any wavelength within a tuning range that is generally much longer than the period of the NPE 112. To keep track of which particular NPE period the laser wavelength is operating in, the processor 642 uses knowledge of the laser emission wavelength which is known to within certain limits through the tuning currents, Iaᵢ, Ibᵢ, and Icᵢ. By selecting the NPE FSR to be longer than the uncertainty in the laser wavelength, the laser may be locked to any predefined wavelength by maintaining the two detector values u1 and u2 at predetermined values. The uncertainty in the laser wavelength arises due to uncertainty in the current level and in aging of the laser characteristics, for example a long term drift in tuning characteristic of a tuning section 650, 656 or 658 in the laser with respect to current, or a change in the current Ig applied to the gain section 644 required to achieve a specific level of output power.

In the embodiment illustrated in FIG. 6, a portion of the light output from the laser 602 is directed by splitter 610 to the NPE 612. The detector unit 628, having detectors 628a and 628b, detects the fringe pattern reflected from the NPE 612. The signals u1 and u2, from detectors 628a and 628b respectively, are directed to an amplifier/digitizer unit 664, where the signals are amplified and digitized. The digitized signals are directed to the control processor 662 for processing.

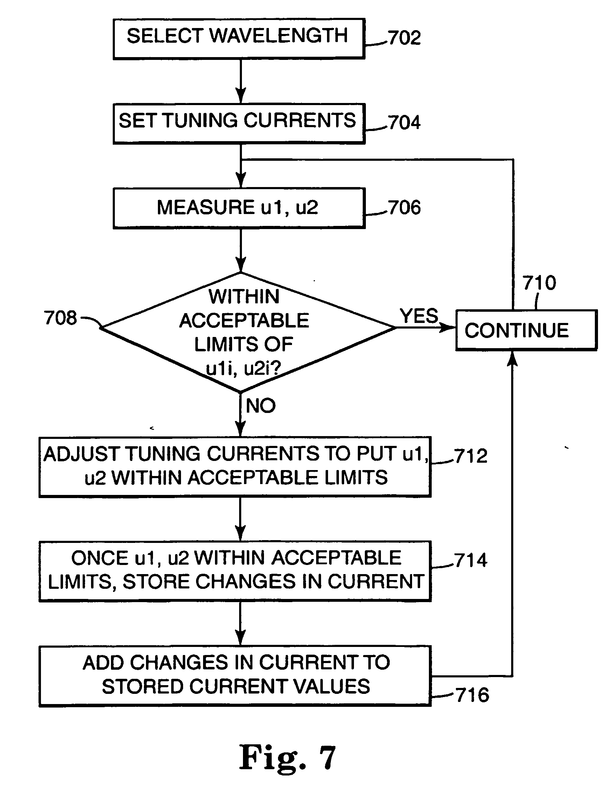

Steps of one particular embodiment of a method for locking the wavelength of the laser 602 are listed in FIG. 7. First, at step 702, the operating wavelength, λᵢ, is selected by the processor 662. The processor extracts the appropriate tuning currents Iaᵢ, Ibᵢ, and Icᵢ from memory 660 and directs the current supply 642 to apply the tuning currents Iaᵢ, Ibᵢ, and Icᵢ to the laser 602, step 704. The signals u1 and u2 are measured, amplified and digitized in the amplifier/ADC 664, at step 706, and are compared by the processor 662 with the calibrated values u1ᵢ and u2ᵢ appropriate for the wavelength λᵢ, at step 708. If the measured values of u1 and u2 are within acceptable tolerances of u1ᵢ and u2ᵢ, then the control loop continues, step 710, and proceeds with further monitoring of the wavelength. The acceptable tolerances of u1ᵢ and u2ᵢ are set so that the wavelength of the laser 602 lies within the tolerance allowed under the ITU standards, for example 3 GHz for a 50 GHz channel spacing.

If it is determined, at step 708, that the measured values of u1 and u2 are not within the permitted tolerances, then one or more of the tuning currents Ia, Ib, and Ic are adjusted to correct the values of u1 and u2, at step 712. Typically, the fine tuning current, Ic, is adjusted first. In most cases, where the laser characteristics have not changed significantly since the previous measurement of u1 and u2, adjustment of Ic is sufficient to correct u1 and u2, thus returning the laser emission wavelength to the selected standard value. If adjustment of Ic alone is insufficient to correct the laser emission wavelength, then both the intermediate tuning current, Ib and fine tuning current Ic may be adjusted in order to correct the values of u1 and u2.

Once the laser emission wavelength has been corrected, the differences between the set current values and those current values required to obtain the desired emission wavelength are stored, at step 714. For example, if only Ic is adjusted to correct the emission wavelength, then the processor stores a current correction value ΔIc. The current correction values may be added to the set current values, at step 716, to update the look-up table that contains the set current values. For example, if only Ic is adjusted to correct the emission wavelength, then the set values Ic₁....Icₙ may be corrected by adding ΔIc

It will be appreciated that the temperature of the laser 602 is normally kept constant, so that variations in operation of the laser with respect to temperature may be ignored. Thus, Ig set to maintain constant output power, at least with respect to temperature variations. The current lg required to produce a given output power may increase over the lifetime of the laser as the laser ages. Where the temperature of the laser 602 is not kept constant, the memory 660 may store a look up table for the various tuning and power currents, along with values of u1 and u2, for each standard wavelength as a function of temperature. It will also be appreciated that any other parameter that changes the laser wavelength, such as temperature, may be used to tune the laser to the desired wavelength, in addition to tuning current, and the resulting parameter value stored.

In the present invention, the NPE's FSR does not need to be closely matched to the optical channel spacing of the WDM system, unlike some prior art approaches. The NPE's FSR is advantageously chosen to be broader than the channel spacing, in order to reduce the risk for ambiguous wavelength readings if the tuning characteristics of the laser 602 change over time. The fact that that the NPE's FSR need not match the channel spacing is advantageous, since it strongly relaxes the needed tolerances of component manufacturing and alignment. Such relaxed tolerances constitute an important difference between the present invention and approaches that use planar etalons.

On the other hand, the present invention does not preclude that the NPE's FSR is simultaneously matched to the WDM channel spacing and that the NPE reflection/transmission peaks are aligned with the standard ITU wavelengths. In some circumstances, it may be desirable to match the NPE's FSR with the channel spacing and also to match a particular periodic feature of reflection/transmission response with the ITU wavelengths, a condition referred to herein as etalon matched operation. An advantage of etalon matched operation is that the fringe phase detected for each channel wavelength is the same and so the need for storing values of u1 and u2 for each channel wavelength is relaxed.

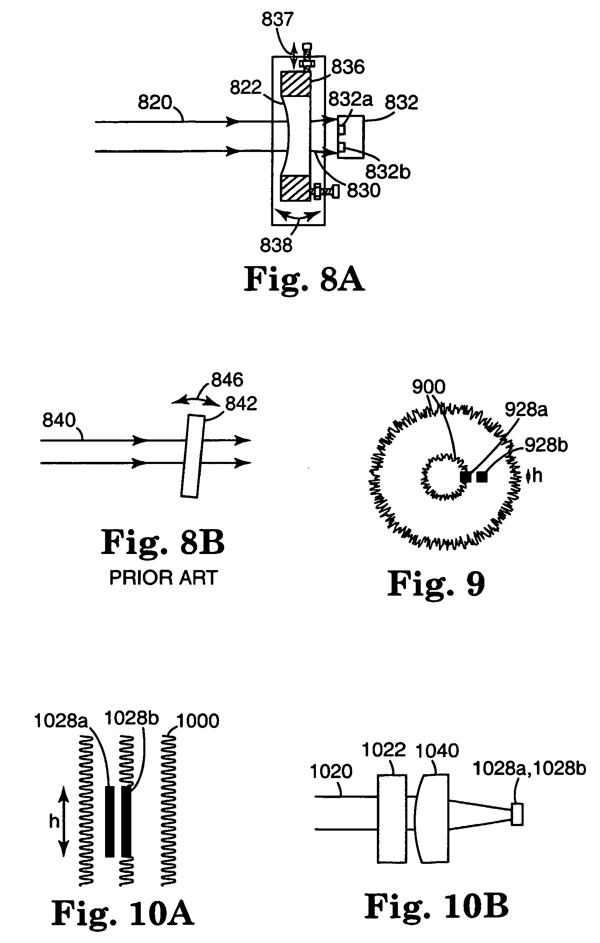

Etalon matched operation may be achieved with the NPE, even if the NPE is not manufactured to strict tolerances, by translating the NPE across the probe beam and by tilting the NPE relative to the probe beam. This may be achieved, for example, using the embodiment illustrated in FIG. 8A, which schematically shows a probe beam 820 incident on a NPE 822. In this particular embodiment, the beam 830 transmitted through the NPE 822 is incident on a detector unit 832 having two detecting portions 832a and 832b. A certain fixed value of the fringe pattern may be incident on the detector unit 832 through judicious placement of the detector. It will be appreciated that a detector unit disposed to detect the beam reflected by the NPE 822 may also be used. The NPE 822 is held in a mount 836 that provides translation across the probe beam 820, as indicated by the arrow 837, and tilt relative to the probe beam 820, as indicated by the arrow 838. The mount 836 may include a screw translator, translation stage or some other suitable mechanism for translating the NPE 822 across the beam 820. The mount 836 may also include a pivot to provide tilt adjustment. A certain fixed value of the fringe pattern may be incident on the detector unit 832 through judicious placement of the detector unit 832.

The NPE 822 may be translated and rotated to set the FSR and the reflection/transmission peak wavelength to any desired values within respective ranges determined in part by the NPE's range of thickness, the radius of curvature of the NPE's non-planar surface or surfaces, and the reflectivity of the NPE's surfaces. This is possible since the NPE 822 offers two degrees of freedom in its alignment, namely translational position and tilt. For example, by tilting the NPE in the probe beam, the nominal optical path length through the NPE is changed, and thereby the FSR is changed. Similarly, by translating the NPE across the probe beam, the fringe patterns move on the detectors, thereby matching an intensity peak to the current operating wavelength. It will be appreciated that, when aligned in this way, a single detector may be used in place of a dual detector, and that any another periodic feature of the fringe pattern, such as a particular value of the detected power, or its derivative(s) with respect to wavelength, may be used in place of the intensity peak.

This advantage is not present when planar etalons are used, as is schematically illustrated in FIG. 8B. Translation of a planar etalon 842 across the probe beam 840 does not result in a change of thickness of the optical path length through the planar etalon 842, and so the fringe pattern produced by the planar etalon 842 does not shift with translation of the planar etalon 842. The only degree of freedom in adjusting a planar etalon 842 is in its tilt relative to the probe beam 840, as illustrated by arrow 846. Consequently, the planar etalon 842 is required to be manufactured with a very precise thickness so that the FSR matches the WDM channel spacing.

The NPE may have at least one curved surface. The invention is operable for different types of topology selected for the curved surface or surfaces. For example, in a NPE having one curved surface and one planar surface, the one curved surface may be circularly symmetric surface, such as a spherical surface or an aspherical surface. The curved surface may also be a cylindrical surface, and may be circularly cylindrical, or non-circularly cylindrical. Circularly cylindrical means that the curved surface, in a plane parallel with a radius of curvature, describes an arc of a circle, whereas non-circularly cylindrical means that the curved surface does not describe an arc of a circle. The curved surface may also be toroidal.

Where the curved surface or surfaces are spherical or aspherical, the fringe pattern produced by the NPE is typically circular. FIG. 9 schematically illustrates a circular fringe pattern 900 incident on a pair of detectors 928a and 928b, looking along the direction of incidence of the light on the detectors 928a and 928b. The extent, h, of the detectors 928a and 928b in the direction perpendicular to the line separating the detectors 928a and 928b is limited, so that the detecting areas of the detectors 928a and 928b do not overlap both bright and dark fringes. Thus, the accuracy of the measurement of the fringe brightness is maintained.

Where the curved surface or surfaces are cylindrical, or the NPE is wedged, the fringe pattern produced by the NPE is typically linear. FIG. 10 schematically illustrates a linear fringe pattern 1000 incident on a pair of detectors 1028a and 1028b, looking along the direction of incidence of the light on the detectors 1028a and 1028b. Unlike the case illustrated in FIG. 9, the extent, h, of the detectors in the direction perpendicular to the direction of separation between the detectors need not be limited. The detectors 1028a and 1028b may extend up to the full height of the fringes. A result of this arrangement is that the detectors 1028a and 1028b receive more light than in the configuration illustrated in FIG. 9. Advantages of this approach are that the signal to noise ratio (SNR) in the detection of u1 and u2 may be increased, and that less light may be directed to the NPE, resulting in more light being directed as useful output from the laser system.

Another arrangement, using a cylindrical or wedged NPE 1022, is schematically illustrated in FIG. 10B. In this arrangement, the probe beam 1020 transmitted by the NPE 1022 is focused to the detectors 1028a and 1028b using a cylindrical lens 1040. This arrangement is also advantageous in that the SNR is increased and that the amount of light directed to the useful output may be increased. A cylindrical focusing lens may also be used when detecting the fringe pattern produced by light reflected from a cylindrical or wedged NPE 1022. It will be appreciated that the NPE may also employ a combination of spherical, aspherical and cylindrical surfaces.

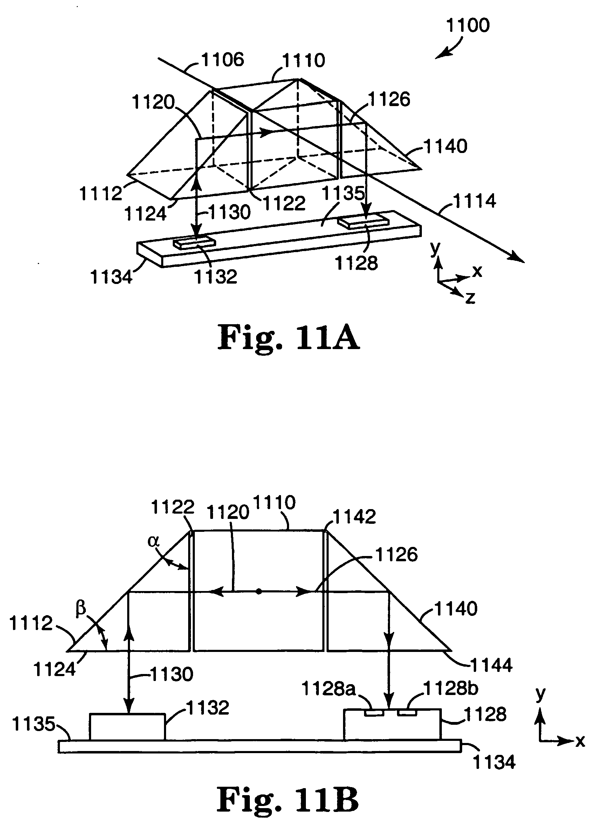

One particular embodiment 1100 of implementing the present invention is shown in FIGs. 11A and 11B. FIG. 11A presents a perspective view while FIG. 11 B presents a view looking along the beam 1114 in the -ve z-direction. The light beam 1106 from the laser (not shown) passes into a beamsplitter cube 1110. Although the beamsplitter cube 1110 may be any suitable size, a useful dimension for the beamsplitter cube is 2 mm x 2 mm x 2 mm. All entrance and exit surfaces of the beamsplitter cube 1110 may be antireflection coated so as to reduce losses. The main fraction of the light passes through the beamsplitter undeviated as output beam 1114.

A fraction of the light beam 1106, for example around 5% is deviated by the beamsplitter cube 1110 as probe beam 1120 towards the first prism 1112. A first fraction of the probe beam 1120, for example 5%-25%, is reflected by the first surface 1122 of the first prism 1112. The remaining portion of the probe beam 1120 undergoes total internal reflection at the prism reflecting surface 1121. A second fraction of the probe beam, for example 5%-25%, is reflected by the second surface 1124 of the prism 1112. The first and second surfaces 1122 and 1124 may be uncoated or may be coated so as to provide a desired level of reflectivity. A useful dimension for the first prism 1112 is to approximately match the dimensions if the beamsplitter cube 1110.

That portion of the probe beam 1130 transmitted through the first prism 1112 is directed as a transmitted beam 1130 towards a power detector 1132. The power detector is typically sufficiently large to detect the entire transmitted beam 1130, and may have a detector area having a diameter in the mage 0.3 m - 2 mm. The power detector 1132 may be mounted on a detector carrier 1134. The detector carrier 1134 may be formed of any suitable mateiral for mounting the detectors, such as a ceramic or plastic having leads and bond pads on its mounting surface 1135.

The first and second fractions of the light reflected respectively by the first and second surfaces 1122 and 1124 of the prism 1112 pass back through the beamsplitter cube 1110 in the direction opposite to the direction of the probe beam 1120. A portion of the first and second fractions of reflected light is lost on passing through the beamsplitter cube 1110. That portion of the first and second fractions of reflected light that pass through the beamsplitter cube form a reflected beam 1126. The reflected beam 1126 enters a beam-steering prism 1140 that directs the reflected beam 1126 to a fringe detector 1128. The beam-steering prism 1140 may have dimensions approximately equal to those of the beamsplitter cube 1110. The input surface 1142 and output surface 1144 of the beam-steering prism 1140 may be antireflection coated in order to reduce loss and prevent the occurrence of a fringe pattern arising from the beam-steering prism 1140. The fringe detector 1128 may be an array of two or more detectors 1128a and 1128b. Any suitable size and separation of detectors 1128a and 1128b may be used. In one particular embodiment, the detectors are 500 µm x 25 µmm with an inter-detector separation of 50 µm - 100 µm. The fringe detector 1128 may also be mounted on the detector carrier 1134.

In this embodiment, the angles, α and β, of the prism 1112 are not both equal to 45°, and so the prism 1112 operates as an NPE, with the first reflected fraction interfering with the second reflected fration at the fringe detector 1128 to form a fringe pattern. In another embodiment, one or both of the reflecting faces 1122 and 1124 may be curved.

A lens may be placed between the beam-steering prism 1140 and the fringe detector 1128 in order to concentrate the fringes on the detectors 1128a and 1128b. In another embodiment, one of the surfaces 1142 and 1144 of the beam-steering prism 1140 prism may be curved so as to focus the beam 1126 on the fringe detector 1128.

Either or both of the prisms 1112 and 1127 may attached to the beamsplitter cube 1110 so as to form a single integral beam-steering unit. Advantages of this embodiment include mounting the detectors 1128 and 1132 on a single carrier 1134, and a reduced apparatus footprint.

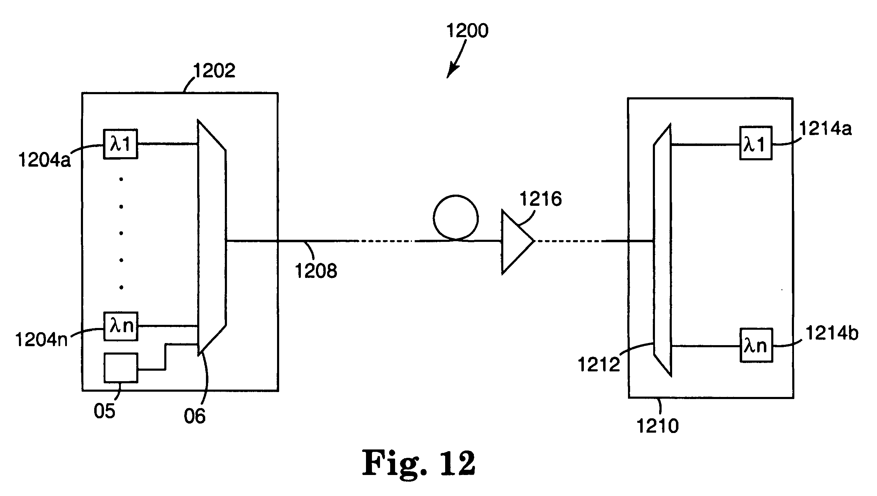

A laser stabilized using the present invention may be employed in a WDM communications system, as illustrated in FIG. 12. The system 1200 includes a WDM transmitter unit 1202 that includes a number of lasers 1204a - 1204n operating at different wavelengths, λ1 - λn. Any of the lasers 1204a - 1204n may be a laser whose wavelength is stabilized according the present invention. In addition, one or more spare lasers 1205 may operate as a substitute if any of the lasers 1204a - 1204n fail. The lasers 1204a -1204n, 1205 may each include modulators for modulating information onto the respective output light beams. The outputs from the lasers 1204a-1204n, 1205 are combined in a WDM combiner arrangement 1206 and launched as a WDM signal into a fiber 1208 that is directed to a WDM receiver 1210. The fiber 1208 may include one or more fiber amplifier stages 1218 to amplify the WDM signal as it propagates to the WDM receiver 1210. The WDM receiver 1210 demultiplexes the WDM signal in a demultiplexer 1212 and directs signals at different wavelengths λ1 - λn to respective detectors 1214a-1214n.

As noted above, the present invention is applicable to stabilizing the wavelength of lasers and is believed to be particularly useful for locking the operating wavelength of a tunable diode laser to one of a set of standard optical communications channel wavelengths. The present invention should not be considered limited to the particular examples described above, but rather should be understood to cover all aspects of the invention as fairly set out in the attached claims. Various modifications, equivalent processes, as well as numerous structures to which the present invention may be applicable will be readily apparent to those of skill in the art to which the present invention is directed upon review of the present specification. The claims are intended to cover such modifications and devices.

## Claims

1. A laser system, comprising:
laser means (102, 602) for producing output light (106);
fringe-producing means (212, 232, 252) for forming an etalon fringe pattern disposed in a first portion (120) of the output light, the fringe-producing means producing an interference fringe pattern from the first portion of the output light; and
light detector means (128, 628, 832, 1128) including first (128a, 628a, 1028a, 1128a) and second (128b, 628b, 1028b, 1128b) light detector elements disposed to detect respective first and second portions of the fringe pattern, **characterized in that** the fringe-producing means have at least one non-planar surface (224, 242, 262, 264).

2. A laser system according to claim 1, comprising:
the laser means (102, 602) for producing output light (106);
the fringe-producing means (122, 212, 232, 252, 1112) disposed in the first portion of the output light to reflect a second light beam containing the interference fringe pattern; and
the light detector means having at least the first and second light detector elements (128a, 128b, 1128a, 1128b) disposed to detect at least two portions of the fringe pattern reflected from the fringe-produdng means and to determine a wavelength of the output light based on a position of the fringe pattern relative to the light detector elements, the light detector means also having power detector means (132, 1132) disposed to detect output light transmitted through the fringe-producing means and produce a power signal indicative of the output light power transmitted through the fringe-producing means.

3. A laser system as recited in claims 1-2, further comprising a control means (140) coupled to provide drive current to the laser means (102, 602) and one or more tuning currents to the laser means, the control unit being coupled to receive detector signals from the detector means (128, 628), and controlling the one or more tuning currents in response to the received detector signals.

4. A laser system as recited in claim 3, wherein the control means includes a memory unit, the memory unit (660) includes information relating specific tuning current levels to corresponding laser operating wavelengths, and the control unit selects a set of one or more tuning currents to operate the laser at a selected operating wavelength and adjusts the one or more tuning currents in response to the detector signals to align the actual laser operating wavelength with the selected operating wavelength.

5. A laser system as recited in claim 1, wherein the light detector means further comprises power detector means disposed to detect light from the laser and produce a power signal in response to the detected light.

6. A laser system as recited in claim 5, further comprising a control unit coupled to receive the power signal from the power detector means, the control unit controlling a drive current to the laser in response to the received power signal.

7. A laser system as recited in claims 1-2, wherein fringes in the fringe pattern are spaced apart by a fringe spacing, the first and second light detector elements are spaced apart to detect portions of the fringe pattern spaced apart by a value different from an integral number of half fringe spacings.

8. A laser system as recited in claim 7, wherein the portions of the fringe pattern detected by the first and second light detector elements are spaced apart by approximately one quarter of the fringe spacing plus an integral number of half fringe spacings.

9. A laser system as recited in claims 1-2, wherein the fringe-producing means includes input and output surfaces of an internally reflecting prism.

10. A laser system as recited in claim 1, wherein the non-planar surface is a circularly symmetrical curved surface.

11. A laser system as recited in claim 1, wherein the non-planar surface is a cylindrical surface or a toroidal surface.

12. A laser system as recited in claims 1 or 2, wherein the fringe-producing means is mounted in a mount providing at least two degrees of freedom relative to the first portion of the output light.

13. A laser system as recited in claims 1 or 2, further comprising a fiber communications link having a first end coupled to receive a second portion of the output light and a wavelength division multiplexed receiver coupled at a second end of the fiber communications link to detect the output light after propagating along the fiber communications channel.

14. A laser system as recited in claim 13, further comprising at least one other laser coupled to feed light into the fiber communications channel.

15. A laser system as recited in claims 1 or 2, further comprising a collimator disposed on a light path between the laser and the fringe-producing means to reduce divergence of the output light from the laser and a beamsplitter disposed, between the collimator and the fringe-producing means, on the light path, a minor portion of the output light propagating from the beamsplitter to the fringe-producing means, and a major portion of the output light propagating from the beamsplitter to an output optical fiber.

16. A laser system as recited in claim 12, wherein the laser is operated at one of a set of discrete optical channel frequencies having uniform interchannel frequency spacing, the free spectral range of the fringe-producing element etalon being matched to the interchannel frequency spacing, and one of a transmission and reflection maximum of the fringe-producing element being matched to one of the discrete optical channel frequencies, by translational and tilt adjustment of the fringe-producing element.

17. A method of stabilizing an operating wavelength of a laser (102, 602), comprising:
illuminating a fringe-producing element (212, 232, 252) with light from the laser so as to produce an interference fringe pattern;
detecting amounts of light in first and second portions of the fringe pattern; and
adjusting the operating wavelength of the laser in response to the detected amounts of light in the first and second portions of the fringe pattern,
**characterized in that** the fringe-producing element has at least one non-planar surface.

18. A method of stabilizing an operating wavelength of a laser (102, 602) according to claim 17, comprising:
forming an interference fringe pattern using light generated by the laser incident on a reflective, fringe-producing element;
detecting amounts of light in first and second portions of the fringe pattern reflected from the fringe-producing element;
detecting light transmitted through the fringe-producing element to produce a signal indicative of the output power of the laser; and
adjusting the operating wavelength of the laser in response to the detected amounts of light in the first and second portions of the fringe pattern.

19. A method as recited in claim 17, wherein detecting the amounts of light in the first and second portions of the interference fringe pattern includes detecting light reflected by the fringe-producing element.

20. A method as recited in claims 17 and 18, further comprising detecting power of light output from the laser to produce a signal indicative of output power from the laser.

21. A method as recited in claim 20, further comprising adjusting an operating power of the laser in response to the signal indicative of output power.

22. A method as recited in claim 17, wherein detecting the amounts of light in the first and second portions of the fringe pattern includes detecting light transmitted through the fringe-producing element.

23. A method as recited in claims 17-18, wherein the first portion of the fringe pattern is spaced apart from the second portion of the fringe pattern by an amount different from an integral number of half fringe spacings.

24. A method as recited in claim 23, wherein the first portion of the fringe pattern is spaced apart from the second portion of the fringe pattern by an amount approximately equal to an integral number of half fringe spacings plus a quarter fringe spacing.

25. A method as recited in claims 17 and 18, further comprising adjusting position of the fringe-producing element in a direction perpendicular to a direction of the light incident on the fringe-producing element and in a tilt direction relative to the light incident on the fringe-producing element.

26. A method as recited in claims 17-18, wherein adjusting the operating wavelength of the laser comprises adjusting one or more tuning currents applied to the laser in response to the detected amounts of light.

27. A method as recited in claim 26, wherein adjusting the one or more tuning currents comprises selecting a set of one or more tuning currents corresponding to a desired laser operation wavelength, and adjusting the one or more tuning currents to correspond with the selected set of one more tuning currents to align the actual laser operating wavelength with the desired operating wavelength.

## Patentansprüche

1. Lasersystem mit:
Laserrnitteln (102, 602) zum Erzeugen von Ausgangslicht (106);
Streifen-Erzeugungsmitteln (212, 232, 252) zum Erzeugen eines Etalon-Streifenbilds, das sich in einem ersten Teil (120) des Ausgangslichts befindet, wobei die Streifen-Erzeugungsmittel ein Interferenzstreifenbild von dem ersten Teil des Ausgangslichts erzeugen; und
Lichtdetektionsmitteln (128, 628, 832, 1128) mit ersten Lichtdetektionselementen (128a, 628a, 1028a, 1128a) und zweiten Lichtdetektionselementen (128b, 628b, 1028b, 1128b), die so eingerichtet sind, dass sie einen ersten bxw, zweiten Teil des Streifenbilds detektieren,
**dadurch gekennzeichnet, dass** die Streifen-Erzeugungsmittel mindestens eine nichtplanare Fläche (224, 242, 262, 264) haben.

2. Lasersystem nach Anspruch 1 mit:
den Lasermitteln (102, 602) zum Erzeugen von Ausgangslicht (106);
den Streifen-Erzeugungsmitteln (122, 212, 232, 252, 1112), die in dem ersten Teil des Ausgangslichts so angeordnet sind, dass sie einen zweiten Lichtstrahl, der das Interferenzstreifenbild enthält, reflektieren; und
den Lichtdetektionsmitteln mit mindestens den ersten und zweiten Lichtdetektionseiementen (128a, 128b, 1128a, 1128b), die so eingerichtet sind, dass sie mindestens zwei Telle des von den Streifen-Erzeugungsmitteln reflektierten Streifenbilds detektieren und eine Wellenlänge des Ausgangslichts aufgrund einer Lage des Streifenbilds in Bezug auf die Lichtdetektionsmittel ermitteln, wobei die Lichtdetektionsmittel außerdem Leistungsdetektionsmittel (132, 1132) haben, die so eingerichtet sind, dass sie Ausgangslicht, das durch die Streifen-Erzeugungsmittel durchgelassen wird, detektieren und ein Leistungssignal erzeugen, das die Leistung des durch die Streifen-Erzeugungsmittel durchgelassenen Ausgangslichts angibt.

3. Lasersystem nach Anspruch 2, das weiterhin Steuermittel (140) aufweist, die so verbunden sind, dass sie Ansteuerungsstrom für die Lasermittel (102, 602) und einen oder mehrere Abstimmströme für die Lasermittel bereitstellen, wobei die Steuereinheit so verbunden ist, dass sie Detektorsignale von den Detektionsmitteln (128, 628) empfängt, und den einen oder die mehreren Abstimmströme in Reaktion auf die empfangenen Detektorsignale steuert.

4. Lasersystem nach Anspruch 3, **dadurch gekennzeichnet, dass** die Steuermittel eine Speichereinheit (660) aufweisen, die Informationen enthält, die bestimmte Abstimmstrompegel in Beziehung zu entsprechenden Laser-Betriebswellenlängen setzen, und die Steuereinheit eine Gruppe eines oder mehrerer Abstimmströme so wählt, dass der Laser auf einer gewählten Betriebswellenlänge betrieben wird, und den einen oder die mehreren Abstimmströme in Reaktion auf die Detektorsignale so einstellt, dass die tatsächliche Laser-Betriebswellenlänge mit der gewählten Betriebswellenlänge abgeglichen wird.

5. Lasersystem nach Anspruch 1, **dadurch gekennzeichnet, dass** die Lichtdetektionsmittel weiterhin Leistungsdetektionsmittel aufweisen, die so eingerichtet sind, dass sie Licht von dem Laser detektieren und in Reaktion auf das detektierte Licht ein Leistungssignal erzeugen.

6. Lasersystem nach Anspruch 5, das weiterhin eine Steuereinheit aufweist, die so verbunden ist, dass sie das Leistungssignal von den Leistungsdetektionsmitteln empfängt, wobei die Steuereinheit einen Ansteuerungsstrom für den Laser in Reaktion auf das empfangene Leistungssignal steuert.

7. Lasersystem nach Anspruch 2, **dadurch gekennzeichnet, dass** Streifen in dem Streifenbild durch einen Streifenabstand räumlich getrennt sind und die ersten und zweiten Lichtdetektionsetemente so räumlich getrennt sind, dass sie Telle des Streifenbilds detektieren, die durch einen Wert räumlich getrennt sind, die von einer ganzen Zahl von halben Streifenabständen verschieden ist.

8. Lasersystem nach Anspruch 7, **dadurch gekennzeichnet, dass** die Teile des Streifenbilds, die von den ersten und zweiten Lichtdetektionselementen detektiert werden, durch etwa ein Viertel des Streifenabstands plus eine ganze Zahl von halben Streifenabständen räumlich getrennt sind.

9. Lasersystem nach Anspruch 2, **dadurch gekennzeichnet, dass** die Streifen-Erzeugungsmittel Eingangs- und Ausgangsflächen eines innenreflektierenden Prismas umfassen.

10. Lasersystem nach Anspruch 1, **dadurch gekennzeichnet, dass** die nichtplanare Fläche eine kreissymmetrische gekrümmte Fläche ist.

11. Lasersystem nach Anspruch 1, **dadurch gekennzeichnet, dass** die nichtplanare Fläche eine zylindrische Fläche oder eine torische Wölbung ist.

12. Lasersystem nach Anspruch 1 oder 2, **dadurch gekennzeichnet, dass** die Streifen-Erzeugungsmittel in einer Halterung befestigt sind, die mindestens zwei Freiheitsgrade in Bezug auf den ersten Teil des Ausgangslichts gewährleistet.

13. Lasersystem nach Anspruch 1 oder 2, das weiterhin eine Glasfaser-Kommunikationsverbindung mit einem ersten Ende, das so verbunden ist, dass es einen zweiten Teil des Ausgangslichts empfängt, und einen Wellenlängenmultiplex-Empfänger aufweist, der an einem zweiten Ende der Giesfaser-Kommunikationsverbindung so verbunden ist, dass er das Ausgangslicht nach Ausbreitung entlang dem Glasfaser-Kommunikationskanal detektiert.

14. Lasersystem nach Anspruch 13, das weiterhin mindestens einen weiteren Laser aufweist, der so verbunden ist, dass er Licht in den Glasfaser-Kommunikationskanal einspeist.

15. Lasersystem nach Anspruch 2, das weiterhin einen Kollimator, der In einem Lichtweg zwischen dem Laser und den Streifen-Erzeugungsmitteln so angeordnet ist, dass er eine Divergenz des Ausgangslichts von dem Laser verringert, und einen Strahlenteiler, der in dem Lichtweg zwischen dem Kollimator und den Streifen-Erzeugungsmitteln angeordnet ist, aufweist, wobei sich ein kleinerer Teil des Ausgangslichts von dem Strahlenteiler zu den Streifen-Erzeugungsmitteln ausbreitet und sich ein größerer Teil des Ausgangslichts von dem Strahlenteiler zu einer Ausgangs-Glasfaser ausbreitet.

16. Lasersystem nach Anspruch 12, **dadurch gekennzeichnet, dass** der Laser auf einer Frequenz einer Gruppe von diskreten optischen Kanalfrequenzen mit einheitlichem Kanal-Frequenzabstand betrieben wird, wobei der freie Spektralbereich des Streifen-Erzeugungselement-Etalons an den Kanal-Frequenzabstand angepasst wird, und dass eines der Durchlässigkeits- und Reflexionsmaxima des Streifen-Erzeugungselements durch Translations- und Neigungseinstellung an eine der diskreten optischen Kanalfrequenzen angepasst wird.

17. Verfahren zum Stabilisieren einer Betriebswellenlänge eines Lasers (102, 602) mit den Schritten:
Anstrahlen eines Streifen-Erzeugungselements (212, 232, 252) mit Ucht von dem Leser, um ein Interferenzstreifenbild zu erzeugen;
Detektieren von Lichtmengen in einem ersten und zweiten Teil des Streifenbilds und
Einstellen der Betriebswellenlänge des Lasers in Reaktion auf die detektierten Lichtmengen in dem ersten und zweiten Teil des Streifenbilds,
**dadurch gekennzeichnet, dass** das Streifen-Erzeugungselement mindestens eine nichtplanare Fläche hat.

18. Verfahren zum Stabilisieren einer Betriebswellenlänge eines Lasers (102, 602) nach Anspruch 17 mit den Schritten:
Erzeugen eines Interferenzstreifenbilds mittels Licht, das von dem Laser erzeugt wird, der auf einem reflektierenden Streifen-Erzeugungselement auftrifft;
Detektieren von Lichtmengen in einem ersten und zweiten Teil des Streifenbilds, das von dem Streifen-Erzeugungselement reflektiert wird;
Detektieren von Licht, das durch das Streifen-Erzeugungselement durchgelassen wird, um ein Signal zu erzeugen, das die Ausgangsleistung des Lasers angibt; und
Einstellen der Betriebswellenlänge des Lasers In Reaktion auf die detektierten Lichtmengen in dem ersten und zweiten Teil des Streifenbilds.

19. Verfahren nach Anspruch 17, **dadurch gekennzeichnet, dass** das Detektieren der Lichtmengen in dem ersten und zweiten Teil des Interferenzstreifenbilds das Detektieren von Licht, das von dem Streifen-Erzeugungselement reflektiert wird, umfasst.

20. Verfahren nach den Ansprüchen 17 und 18, das weiterhin das Detektieren der Lichtleistung umfasst, die von dem Laser abgegeben wird, um ein Signal zu erzeugen, das die von dem Laser abgegebene Leistung angibt.

21. Verfahren nach Anspruch 20, das weiterhin das Einstellen einer Betriebsleistung des Lasers in Reaktion auf das Signal, das die Ausgangsleistung angibt, umfasst.

22. Verfahren nach Anspruch 17, **dadurch gekennzeichnet, dass** das Detektieren der Lichtmengen in dem ersten und zweiten Teil des Streifenbilds das Detektieren von Licht, das durch das Streifen-Erzeugungselement durchgelassen wird, umfasst.

23. Verfahren nach den Ansprüchen 17 - 18, **dadurch gekennzeichnet, dass** der erste Teil des Streifenbilds von dem zweiten Teil des Streifenbilds durch einen Betrag räumlich getrennt wird, der von einer ganzen Zahl von halben Streifenabständen verschieden ist.

24. Verfahren nach Anspruch 23, **dadurch gekennzeichnet, dass** der erste Teil des Streifenbilds von dem zweiten Teil des Streifenbilds durch einen Betrag räumlich getrennt wird, der ungefähr gleich einer ganzen Zahl von halben Streifenabständen plus einem Viertel-Streifenabstand ist.

25. Verfahren nach den Ansprüchen 17 und 18, das weiterhin das Einstellen der Lage des Streifen-Erzeugungselements senkrecht zu einer Richtung des auf das Streifen-Erzeugungselement auftreffenden Lichts und schräg zu dem auf das Streifen-Erzeugungselement auftreffenden Licht umfasst.

26. Verfahren nach den Ansprüchen 17 - 18, **dadurch gekennzeichnet, dass** das Einstellen der ßetriedswellenlänge des Lasers das Einstellen eines oder mehrerer Abstimmströme, die in den Laser eingespeist werden, in Reaktion auf die detektierten Lichtmengen umfasst.

27. Verfahren nach Anspruch 26, **dadurch gekennzeichnet, dass** das Einstellen des einen oder der mehreren Abstimmströme das Wählen einer Gruppe eines oder mehrerer Abstimmströme, die einer gewünschten Laser-Betriebswellenlänge entsprechen, und das Einstellen des einen oder der mehreren Abstimmströme so, dass er/sie der gewählten Gruppe einer oder mehrerer Abstimmströme entspricht/entsprechen, um die tatsächliche Laser-Betriebswellenlänge mit der gewünschten Betriebswellenlänge abzugleichen, umfasst.

## Revendications

1. Système laser comprenant :
un moyen laser (102, 602) pour produire une lumière de sortie (106) ;
des moyens produisant les franges (212, 232, 252) pour former un motif en franges étalon disposé dans une première partie (120) de la lumière de sortie, les moyens produisant les franges produisant un motif de franges d'interférence à partir de la première partie de la lumière de sortie ; et
un moyen détecteur de lumière (128, 628, 832, 1 128) incluant les premier (128a, 628a, 1 028a, 1 128a) et second (128b, 628b, 1 028b, 1 128b) éléments détecteurs de lumière disposés pour détecter les première et seconde parties respectives du motif en franges, **caractérisé en ce que** les moyens produisant les franges ont au moins une surface non plane (224, 242, 262, 264).

2. Système laser selon la revendication 1, comprenant :
le moyen laser (102, 602) pour produire une lumière de sortie (106) ;
les moyens produisant les franges (122, 212, 232, 252, 1 112) disposés dans la première partie de la lumière de sortie pour réfléchir un second faisceau lumineux contenant le motif des franges d'interférence ; et
le moyen détecteur de lumière ayant au moins les premier et second éléments détecteurs de lumière (128a, 128b, 1 128a, 1 128b) disposés pour détecter au moins deux parties du motif en franges réfléchies des moyens produisant les franges et pour déterminer une longueur d'onde de la lumière de sortie à partir d'une position du motif en franges par rapport aux éléments détecteurs de lumière, le moyen détecteur de lumière ayant également des moyens détecteurs de puissance (132, 1 132) disposés pour détecter la lumière de sortie transmise à travers les moyens produisant les franges et pour produire un signal de puissance indicatif de la puissance de la lumière de sortie transmise à travers les moyens produisant les franges.

3. Système laser comme exposé dans les revendications 1 à 2, comprenant, en outre, un moyen de commande (140) couplé pour fournir un courant d'entraînement au moyen laser (102, 602) et un ou davantage de courants de réglage au moyen laser, l'unité de commande étant couplée pour recevoir les signaux de détection provenant du moyen détecteur (128, 628) et pour commander le seul ou davantage de courants de réglage en réponse aux signaux de détection reçus.

4. Système laser comme exposé dans la revendication 3, dans lequel le moyen de commande inclut un élément de mémoire, l'élément de mémoire (660) inclut des informations se rapportant aux niveaux de courant de réglage spécifiques pour les longueurs d'onde correspondantes faisant fonctionner le laser et l'unité de commande sélectionne une série d'un ou davantage de courants de réglage pour faire fonctionner le laser à une longueur d'onde de fonctionnement sélectionnée est ajuste le seul ou davantage de courants de réglage en réponse aux signaux de détection pour aligner la véritable longueur d'onde qui fait fonctionner le laser avec la longueur d'onde de fonctionnement sélectionnée.

5. Système laser comme exposé dans la revendication 1, dans lequel le moyen détecteur de lumière comprend, en outre, un moyen détecteur de puissance disposé pour détecter la lumière provenant du laser et pour produire un signal de puissance en réponse à la lumière détectée.

6. Système laser comme exposé dans la revendication 5, comprenant, en outre, une unité de commande couplée pour recevoir le signal de puissance du moyen détecteur de puissance, l'unité de commande commandant un courant d'entraînement pour le laser en réponse au signal de puissance reçu.

7. Système laser comme exposé dans les revendications 1 à 2, dans lequel les franges dans le motif en franges sont espacées séparément par un espacement des franges, les premier et second éléments détecteurs de lumière sont espacés séparément pour détecter les parties du motif en franges espacées séparément par une valeur différente d'un nombre entier de la moitié des espacements des franges.

8. Système laser comme exposé dans la revendication 7, dans lequel les parties du motif en franges détectées par les premier et second éléments détecteurs de lumière sont espacées séparément par approximativement un quart de l'espacement des franges plus un nombre entier de la moitié des espacements des franges.

9. Système laser comme exposé dans les revendications 1 à 2, dans lequel le moyen produisant les franges inclut des surfaces d'entrée et de sortie d'un prisme à réflexion de manière interne.

10. Système laser comme exposé dans la revendication 1, dans lequel la surface non plane est une surface arrondie circulairement symétrique.

11. Système laser comme exposé dans la revendication 1, dans lequel la surface non plane est une surface cylindrique ou une surface toroïdale.

12. Système laser comme exposé dans les revendications 1 ou 2, dans lequel le moyen produisant les franges est monté à un support prévoyant au moins deux degrés de liberté par rapport à la première partie de la lumière de sortie.

13. Système laser comme exposé dans les revendications 1 ou 2, comprenant, en outre, une liaison de communication par fibre ayant une première extrémité couplée pour recevoir une seconde partie de la lumière de sortie et un récepteur multiplexé en longueurs d'onde couplé à une seconde extrémité de la liaison de communication par fibre pour détecter la lumière de sortie après une propagation le long de la voie de communication par fibre.

14. Système laser comme exposé dans la revendication 13, comprenant, en outre, au moins un autre laser couplé pour transmettre la lumière dans la voie de communication par fibre.

15. système laser comme exposé dans les revendications 1 ou 2, comprenant, en outre, un collimateur disposé sur un trajet lumineux entre le laser et le moyen produisant les franges pour réduire la divergence de la lumière de sortie provenant du laser et un et un dispositif de division du faisceau optique disposé entre le collimateur et le moyen produisant les franges, sur le trajet lumineux, une petite partie de la lumière de sortie se propageant depuis le dispositif de division du faisceau optique jusqu'au moyen produisant les franges, et une grande partie de la lumière de sortie se propageant depuis le dispositif de division du faisceau optique jusqu'à une fibre optique de sortie.

16. Système laser comme exposé dans la revendication 12, dans lequel le laser est mis à fonctionner à l'une d'une série de fréquences de canal optique discrètes ayant un espacement fréquentiel intercanal uniforme, la plage spectrale libre de l'étalon de l'élément produisant les franges étant adaptée avec l'espacement fréquentiel intercanal, et l'un d'un maximum de transmission et de réflexion de l'élément produisant les franges étant adapté avec l'une des fréquences de canal optique discrètes, par un ajustement en translation et en inclinaison de l'élément produisant les franges.

17. Procédé consistant à stabiliser une longueur d'onde de fonctionnement d'un laser (102, 602) comprenant les étapes consistant à :
éclairer un élément produisant les franges (212, 232, 252) avec une lumière provenant du laser de sort a produit un motif des franges d'interférence ;
détecter les quantités de lumière dans les première et seconde parties du motif en franges ; et
ajuster la longueur d'onde de fonctionnement du laser en réponse aux quantités de lumière détectées dans les première et seconde parties du motif en franges,
**caractérisé en ce que** l'élément produisant les franges a au moins une surface non plane.

18. Procédé consistant à stabiliser une longueur d'onde de fonctionnement d'un laser (102, 602) selon la revendication 17, comprenant les étapes consistant à :
former un motif des franges d'interférence en utilisant la lumière générée par le laser de façon incidente sur un élément produisant les franges, réflectif ;
détecter les quantités de lumière dans les première et seconde parties du motif en franges réfléchies de l'élément produisant les franges ;
détecter la lumière transmise à travers l'élément produisant les franges pour produire un signal indicatif de la puissance de sortie du laser ; et
ajuster la longueur d'onde de fonctionnement du laser en réponse aux quantités de lumière détectées dans les première et seconde parties du motif en franges.

19. Procédé comme exposé dans la revendication 17, dans lequel la détection des quantités de lumière dans les première et seconde parties du motif des franges d'interférence inclut la détection de la lumière réfléchie par l'élément produisant les franges.

20. Procédé comme exposé dans les revendications 17 et 18, comprenant, en outre, la détection de la puissance de la lumière sortie du laser pour produire un signal indicatif de la puissance de sortie du laser.

21. Procédé comme exposé dans la revendication 20, comprenant, en outre, le fait de régler une puissance de fonctionnement du laser en réponse au signal indicatif de la puissance de sortie.

22. Procédé comme exposé dans la revendication 17, dans lequel la détection des quantités de lumière dans les première et seconde parties du motif en franges inclut la détection de la lumière transmise à travers l'élément produisant les franges.

23. Procédé comme exposé dans les revendications 17 à 18, dans lequel la première partie du motif en franges est espacée séparément de la seconde partie du motif en franges par une quantité différente d'un nombre entier de la moitié des espacements des franges.

24. Procédé comme exposé dans la revendication 23, dans lequel la première partie du motif en franges est espacée séparément de la seconde partie du motif en franges par une quantité approximativement égale à un nombre entier de la moitié, des espacements des franges plus un quart de l'espacement des franges.

25. Procédé comme exposé dans les revendications 17 et 18, comprenant, en outre, le fait de régler la position de l'élément produisant les franges dans une direction perpendiculaire à une direction de la lumière incidente sur l'élément produisant les franges et dans une direction d'inclinaison par rapport à la lumière incidente sur l'élément produisant les franges.

26. Procédé comme exposé dans les revendications 17 à 18, dans lequel le fait de régler la longueur d'onde de fonctionnement du laser comprend le fait de régler un ou davantage de courants de réglage appliqués au laser en réponse aux quantités de lumière détectées.

27. Procédé comme exposé dans la revendication 26, dans lequel le fait de régler le seul ou davantage de courants de réglage comprend le fait de sélectionner une série d'un ou davantage de courants de réglage correspondant à une longueur d'onde de fonctionnement de laser souhaitée et le fait de régler le seul ou davantage de courants de réglage pour correspondre avec la série d'un ou davantage de courants de réglage pour aligner la véritable longueur d'onde de fonctionnement de laser avec la longueur d'onde de fonctionnement souhaitée.
